# EUROPEAN PATENT APPLICATION

(11) **EP 0 995 813 A2**
(43) Date of publication of application: **26.04.2000**
(21) Application number: 99120704.4
(22) Date of filing: 19.10.1999
(51) Int. Cl.: C23C 16/04, C23C 16/52, C04B 41/00

(54) **Method and apparatus for measurement of weight during CVI/CVD process**

(30) Priority: 23.10.1998 US 178399
(71) Applicant: The B.F.Goodrich Co., Charlotte, North Carolina 28217-3022 (US)
(72) Inventor: Rudolph, James W., Colorado Springs, Colorado 80906 (US)
(74) Representative: Hilleringmann, Jochen, Dipl.-Ing.

(57) **Abstract**

This invention is in the field of Chemical vapor infiltration and Chemical vapor deposition (CVI/CVD). More specifically, this invention is directed to method and apparatus for weighing parts being subjected to the CVI/CVD process, during the process itself to indicate a weight change thereof. The process may be terminated or altered as desired based upon the weight gain information.

## Description

### BACKGROUND OF THE INVENTION

This invention is in the field of Chemical vapor infiltration and Chemical vapor deposition (CVI/CVD). More specifically, this invention is directed to a method of weighing parts being subjected to the CVI/CVD process, during the process itself.

The purpose of a CVI/CVD process as described herein is to deposit a binding matrix within a porous structure. This process adds mass to the parts, and increases part density. During a CVI/CVD process, there is a correlation between the increase in part weight, and the increase in part density. Under current state of the art, CVI/CVD run times are predetermined, based on the starting densities of the parts, and the anticipated time necessary to process them to a predetermined higher density. However, CVI/CVD runs are never exactly the same due to many variables, and likewise the results of the process vary from run to run. This means that parts may be either too dense, or not dense enough at the predetermined conclusion of a run.

In order to optimize furnace processing time and increase the yield of each run, a method is desired by which the weight change of the parts can be measured during the CVI/CVD process. If the weight change of the parts during the process is known, process parameters such as furnace temperature, reactant gas flow rate, internal furnace pressure and reactant gas reactivity, may be continuously adjusted to increase, decrease, or maintain the densification rate.

### SUMMARY OF THE INVENTION

The principal object of the present invention is to determine the weight change of parts during the CVI/CVD process. According to an aspect of the invention, the furnace is weighed. According to another aspect of the invention, an indicator unit is electrically connected to a means for weighing the furnace, parts are placed in the furnacefor the CVI/CVD process, and the indicator unit is monitored during the CVI/CVD process for the change in weight of the furnace as the change in weight of the parts therein. Another important object of this invention is to control the run time, and the process parameters of each CVI/CVD process based on the weight change of the parts.

### BRIEF DESCRIPTION OF THE DRAWINGS

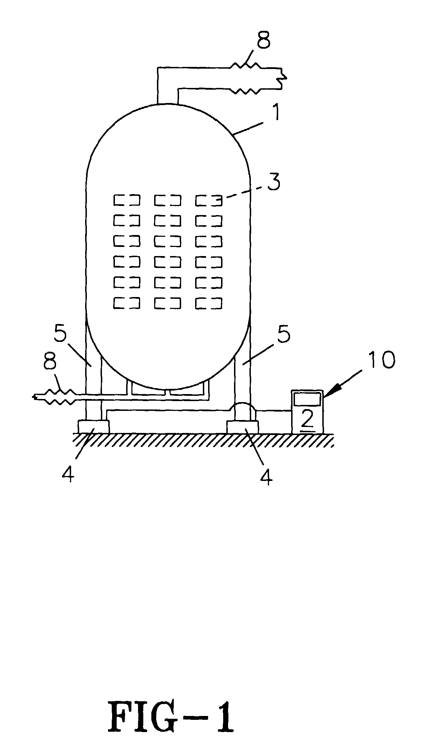

FIG. **1** is a depiction of the furnace on compression load cells.

### DETAILED DESCRIPTION

Various aspects of the invention are depicted in Figure 1, which is not to scale and in which like components are numbered alike. Referring now to Figure 1, according to an aspect of the present invention, a furnace **1** for use in a CVI/CVD process, is disposed upon a weighing device **10**, and the weighing device **10** is configured to indicate the weight of the furnace. According to a further aspect of the invention, the weighing device **10** is also configured to support the furnace. The weighing device **10** may be any device which is capable of being used to determine weight. The weighing device **10** depicted in Figure 1 is the combination of a load cell **4** under each furnace leg **6**, all connected to an indicator unit **2**.

Chemical vapor infiltration and deposition (CVI/CVD) is a well known process for depositing a binding matrix within a porous structure. The term "chemical vapor deposition" (CVD) generally implies deposition of a surface coating, but the term is also used to refer to infiltration and deposition of a matrix within a porous structure. As used herein, the term CVI/CVD is intended to refer to infiltration and deposition of a matrix within a porous part or structure. The technique is particularly suitable for fabricating high temperature structural composites by depositing a carbonaceous or ceramic matrix within a carbonaceous or ceramic porous structure resulting in very useful structures such as carbon/carbon aircraft brake disks, and ceramic combustor or turbine components. The generally known CVI/CVD processes may be classified into four general categories: isothermal, thermal gradient, pressure gradient, and pulsed flow. See W.V. Kotlensky, Deposition of Pyrolytic Carbon in Porous Solids. 8 Chemistry and Physics of Carbon, 173, 190-203 (1973); W.J. Lackey, Review, Status, and Future of the Chemical Vapor Infiltration Process for Fabrication of Fiber-Reinforced Ceramic Composites, Ceram. Eng. Sci. Proc. 10[7-8]577, 577-81 (1989) (W.J.Lackey refers to the pressure gradient process as "isothermal forced flow"). In an isothermal CVI/CVD process, a reactant gas passes around a heated porous structure at absolute pressures as low as a few torr. The gas diffuses into the porous structure driven by concentration gradients and cracks to deposit a binding matrix. This process is also known as "conventional" CVI/CVD. The porous structure is heated to a more or less uniform temperature, hence the term "isothermal". In a thermal gradient CVI/CVD process, a porous structure is heated in a manner that generates steep thermal gradients that induce deposition in a desired portion of the porous structure. The thermal gradients may be induced by heating only one surface of a porous structure, for example by placing a porous structure surface against a susceptor wall, and may be enhanced by cooling an opposing surface, for example by placing the opposing surface of the porous structure against a liquid cooled wall. Deposition of the binding matrix progresses from the hot surface to the cold surface. In a pressure gradient CVI/CVD process, the reactant gas is forced to flow through the porous structure by inducing a pressure gradient from one surface of the porous structure to the opposing surface of the porous structure. Flow rate of the reactant gas is greatly increased relative to the isothermal and thermal gradient processes which results in increased deposition rate of the binding matrix. This process is also known as "forced-flow" CVI/CVD. Finally, pulsed flow involves rapidly and cyclically filling and evacuating a chamber containing the heated porous structure with the reactant gas. The cyclical action forces the reactant gas to infiltrate the porous structure and also forces removal of the cracked reactant gas by-products from the porous structure. The furnace configuration may vary substantially depending upon the type of processes, and the various aspects of the invention may be implemented with any of these processes, depending upon the particular configuration. As such, the furnace configuration of Figure 1 is presented by way of example, and is not intended to limit the invention to the specific arrangement presented.

According to the present invention, a method to determine the weight change of parts **3** in a furnace **1** during a CVI/CVD process, comprises weighing the furnace **1**, including contents, during the CVI/CVD process.

Also according to the present invention, the weight change of parts during the CVI/CVD process is monitored by attaching the furnace **1** to a means for weighing the furnace, electrically connecting an indicator unit **2** to the means for weighing the furnace, placing the parts **3** in the furnace for the CVI/CVD process, and monitoring the indicator unit **2** during the CVI/CVD process for the change in weight of the furnace **1** as the change in weight of the parts **3** therein. In a preferred embodiment of the invention, the means for weighing the furnace comprises placing the furnace on load cells. In a specific preferred embodiment the means for weighing the furnace comprises placing load cells **4** under the furnace **1**, such that the weight of the furnace **1** is supported by the load cells **4**. In Figure 1 the load cells **4** are placed under each furnace leg **5**.

In another preferred embodiment, the indicator unit **2** is tared immediately before the process is commenced, such that the indicator unit **2** reflects the change in weight of the parts. In any embodiment of the invention, all connections **8** to the furnace 1 may be flexible, to increase the accuracy of the weight measurement. Increasing the flexibility of the connections generally tends to increase the accuracy of the weight measurement.

According to a further aspect of the present invention, a CVI/CVD process is terminated based on the average weight gain per part. In a specific preferred embodiment, a CVI/CVD process comprises the steps of attaching the furnace **1** to a means for weighing the furnace, electrically connecting an indicator unit **2** to the means for weighing the furnace, placing the parts **3** in the furnace **1** for the CVI/CVD process, monitoring the indicator unit **2** during the CVI/CVD process for the change in weight of the furnace **1** as the change in weight of the parts **3** therein, and terminating the CVI/CVD process when the indicator unit **2** indicates that the parts **3** have gained a prescribed amount of weight. In a preferred embodiment of the invention, the means for weighing the furnace comprises placing the furnace **1** on load cells 4. In a specific preferred embodiment of this CVI/CVD process, the means for weighing the furnace comprises placing load cells **4** under the furnace **1**, such that the entire weight of the furnace **1** is supported by the load cells **4**. In Figure 1 the load cells **4** are placed under each furnace leg 5.

In another preferred embodiment of this process, the indicator unit **2** is tared immediately before the process is commenced, such that the indicator unit **2** reflects the change in weight of the parts **3** directly. In any embodiment of this process, all connections **8** to the furnace **1** may be flexible, to increase the accuracy of the weight measurement.

According to another aspect of the invention, a method to determine the weight change of parts during a CVI/CVD process, comprises the steps of placing the furnace **1** on load cells **4** appropriate for the entire furnace **1** weight plus weight of the parts **3**, attaching an indicator uni**t 2** to the compression load cells **4**, placing the parts **3** in the furnace **1** for the CVI/CVD process, and monitoring the indicator unit **2** during the CVI/CVD process for the change in weight.

In another aspect of the invention, the apparatus for determining the weight change of parts **3** during a CVI/CVD process comprises load cells **4** supporting the furnace **1**, and an indicator unit **2** electrically connected to the load cells **4**.

According to a certain embodiment a furnace weighing 120,000 lbs to 150,000 lbs, is configured to process aircraft brake disks. All connections **8** to the furnace are flexible. One Flexmount Weight Module static strain gage with 45,000 lb capacity load cell manufactured by Mettler, Toledo and Co. is placed under each furnace leg **5**. These load cells are electrically connected to an indicator unit **2,** specifically a Jaguar ™ System Integration Terminal (also manufactured by Mettler, Toledo and Co.) for a cumulative weight measurement such that one indicator unit **2** displays the total weight on all four load cells **4**. Parts with an initial cumulative weight of on the order of a few percent of the furnace weight are then placed in the furnace, and the indicator unit **2** is tared. With this configuration, the weight gain measurement of the parts is accurate to within ± 10% for parts having a lesser weight gain (total weight gain on the order of 1% of the total furnace weight), and is accurate to within ±5% for parts having a greater weight gain (total weight gain on the order of 3% of the total furnace weight). The weight gain measured according to the invention may be less than or equal to 10% of the total furnace weight, may be less than or equal to 5% of the total furnace weight, and may be less than or equal to 3% of the total furnace weight. Weight gains less than or equal to 1% of the total furnace weight have been measured with an accuracy within ± 10%.

According to a further aspect of the invention, the process further comprises the step of monitoring the rate at which the parts gain weight, wherein the rate is influenced by process parameters including furnace temperature, reactant gas flow rate, internal furnace pressure, and reactivity of the reactant gas. The process may further comprise the step of varying at least one of the parameters to achieve a desired rate. For example, CVI/CVD deposition rate tends to decrease as matrix is deposited. It may be desireable to decrease the reactivity of the gas at a later stage in the process in order to promote infiltration of the gas into the parts. This may produce a greater overall weight gain. Other variations are possible.

Though shown vertical, the furnace may be disposed in other orientations, and the weight of the furnace may be measured in any manner suitable for the particular orientation.

Many variations are evident from the description provided herein without departing from the true scope and spirit of the invention as defined by the claims that follow.

## Claims

1. A method to determine the change in weight of parts in a furnace during a CVI/CVD process, comprising the step of: measuring the change in weight of the entire furnace, including contents, during the CVI/CVD process.

2. In combination, a furnace for use in a CVI/CVD process, and a weighing device, the furnace disposed upon the weighing device, the weighing device being configured to indicate the weight of the furnace.

3. A method to determine the weight change of parts during a CVI/CVD process, comprising the steps:
a. attaching a CVI/CVD furnace to a means for weighing the CVI/CVD furnace;
b. electrically connecting an indicator unit to the means for weighing the CVI/CVD furnace;
c. placing the parts in the furnace for the CVI/CVD process; and,
d. monitoring the indicator unit during the CVI/CVD process for the change in weight of the furnace as an indication of the change in weight of the parts therein.

4. The method of Claim 3, wherein the means for weighing the furnace comprises placing load cells under the furnace.

5. The method of Claim 3 further comprising the step of taring the indicator unit immediately before the process is commenced, such that the indicator unit reflects the change in weight of the parts.

6. The method of Claim 3,4, or 5, wherein all connections to the furnace are flexible.

7. A CVI/CVD process, comprising the steps of:
CVI/CVD depositing a binding matrix within parts disposed within the CVI/CVD furnace while weighing the entire CVI/CVD furnace, including contents, to indicate a gain in weight of said porous substrates during the process.

8. The process of Claim 7, further comprising the step of terminating the CVI/CVD process when the substrates have gained a prescribed amount of weight.

9. The process of Claim 7, further comprising the step of weighing the entire CVI/CVD furnace using at least one load cell.

10. The process of Claim 7, further comprising the step of taring the indicator unit immediately before the process is commenced, such that the indicator unit reflects the change in weight of the parts directly.

11. The process of Claim 7 wherein all connections to the furnace are flexible.

12. The process of Claim 7, further comprising the step of monitoring the rate at which the parts gain weight, wherein the rate is influenced by process parameters including furnace temperature, reactant gas flow rate, internal furnace pressure, and reactant gas reactivity, and further comprising the step of varying at least one of the parameters to achieve a desired rate.

13. A method to determine the weight change of parts during a CVI/CVD process, comprising the steps:
a. placing the furnace on load cells;
b. electrically connecting an indicator unit to said load cells;
c. placing the parts in the furnace for the CVI/CVD process; and,
d. monitoring the indicator unit during the CVI/CVD process for the change in weight of the CVI/CVD furnace.

14. Apparatus for monitoring the weight change of parts in a CVI/CVD furnace during a CVI/CVD process, comprising:
a. load cells supporting the CVI/CVD furnace; and,
b. an indicator unit electrically connected to the load cells.
